(19) Europäisches Patentamt
European Patent Office
Office européen des brevets

(11) **EP 3 276 773 A1**

(12) **EUROPEAN PATENT APPLICATION**

(43) Date of publication:
**31.01.2018 Bulletin 2018/05**

(51) Int Cl.:
*H02J 3/38* (2006.01)          *G06Q 50/06* (2012.01)
*G06Q 10/04* (2012.01)        *G01R 22/06* (2006.01)
*H02J 3/00* (2006.01)

(21) Application number: **16305963.7**

(22) Date of filing: **26.07.2016**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **ALCATEL LUCENT**
**92100 Boulogne-Billancourt (FR)**

(72) Inventors:
• **KANOUN, Wael**
  **91620 NOZAY (FR)**
• **MARTIN, Antony**
  **69003 Lyon (FR)**

(74) Representative: **Mouney, Jérôme**
**Alcatel-Lucent International**
**Patent Business**
**Site Nokia Paris Saclay**
**Route de Villejust**
**91620 Nozay (FR)**

(54) **DETECTION OF FRAUDULENT GREEN ENERGY PRODUCERS FOR SECURE SMART GRIDS**

(57)    For detecting fraudulent green energy producers, a monitoring device (MD) linked to a smart meter associated with a household:
calculates the total theoretical energy production (Pt) for the household, by adding an estimated solar energy production (Ps) and an estimated wind energy production (Pw),
compares the total theoretical energy production (Pt) with an energy production (Pm) provided by the smart meter, detects a risk of fraudulent green energy production, if the comparison yields to a deviation

FIG. 2

S1  MD : Pt(Ps, Pw)

S2  MD : comparing Pt with Pm

S3  |Pt − Pm| > Ti or Ta → detection of risk of fraud

S4  MD : storing identifier of houshold

EP 3 276 773 A1

**Description**

FIELD OF INVENTION

The present subject matter generally relates to the management and monitoring of smart grids.

BACKGROUND

Public utility services are well known in which an organization ("utility company") maintains an infrastructure for a public service and, using that infrastructure, delivers a corresponding service to the public such as, for example, electricity, natural gas or water service. At the end user premises, metering devices measure the user's utility consumption, and the utility company periodically bills the customer according to the consumption information obtained from the meter.

Historically, and in many existing systems, the utility company performs manual reading of the meters (e.g., by a human meter reader walking around neighborhoods to read consumer meters, or driving by with a truck and remotely querying consumer meters by a radio connection). Typically, in such systems, consumer meters are checked on a relatively infrequent basis (e.g., monthly or bi-monthly) and the customer is charged a flat rate based on the total utility consumption during the relevant period. More recently, at least in the case of electrical utilities, there is a trend toward next-generation "smart meters" that enable the electric company to monitor consumer consumption data in nearly real-time. An electrical distribution system equipped with smart meters is often referred to as a "smart grid." One of the advantages of the smart grid is that it enables the electric company to implement time-dependent pricing policies, for example, to charge higher rates during hours of peak energy demand and lower rates at different times of day when there is lower energy demand.

Smart Grids offer unprecedented means for better management of power production and distribution. Moreover, there is an emergence of renewable energy (wind, solar) production at individual users. These users can produce electrical energy for their own use, or even sell their production to the electricity company. In numerous countries, electricity companies have the obligation to purchase the energy produced by their clients as means to reduce pollution and the reliance on non-renewable energy. It goes even further as the obligation of electricity operator is to buy the "green energy" at high and very rewarding/advantageous price (from the users) in order to encourage such green energy production.

The production of renewable energy induces a new security risk to the power industry: fraudulent declaration of produced energy. In other words, the user sends fraudulent amount of produced energy, in order to expect higher payoff from the electricity company. This can be achieved technically by:

Tempering the (smart) meters that measures the produced energy

Using illegal energy production sources as agreed. In some cases, a user can use non-renewable energy sources to produce energy. Such energy as it is not originated from agreed sources (e.g. Solar, Wind) should be detected as fraudulent attempt to increase the declared energy production for a user.

Finally, there is a need for providing enhanced security to smart grids by detecting fraudulent declaration/measurements of production of energy from renewable sources. This will enhance the security of smart grids by detecting malevolent users that provides fraudulent electricity production.

SUMMARY

This summary is provided to introduce concepts related to the present inventive subject matter. This summary is not intended to identify essential features of the claimed subject matter nor is it intended for use in determining or limiting the scope of the claimed subject matter.

In one implementation, a method for detecting fraudulent green energy producers, the method comprising the following steps in a monitoring device linked to a smart meter associated with a household:

calculating a total theoretical energy production for the household, by adding an estimated solar energy production and an estimated wind energy production,
comparing the total theoretical energy production with an energy production provided by the smart meter,
if the comparison yields to a deviation, detecting a risk of fraudulent green energy production.

Advantageously, the method provides a unique approach to detect malevolent users that provides fraudulent data regarding their green energy production. Moreover, it provides an accurate way to detect such fraudulent users by correlating their production data with the weather information. Hence, smart grids operators can stop the financial loss that results from buying unproduced green energy. Moreover, the invention enables such operators to increase their confidence in the green energy production metrics.

In an embodiment, the monitoring device stores in a database an identifier of the household that is fraud suspect.

In an embodiment, the monitoring device performs a difference between the total theoretical energy production and the energy production provided by the smart meter and compares the result of the difference with a threshold, and said comparison yields to a deviation if the result of the difference is above a given threshold.

In an embodiment, the estimated solar energy production depends on a function of time taking into account information related to solar panels associated with the household and solar forecast information.

In an embodiment, the estimated wind energy production depends on a function of time taking into account information related to turbines associated with the household and wind forecast information.

In an embodiment, the monitoring device consults a database storing information about the electricity production units of other households located in the same area as said household and storing a history of energy productions related to said other households, calculates an average of each of the solar forecast information and wind forecast information from the energy productions related to said other households, compares the solar forecast information and wind forecast information for said smart meter with the calculated average of solar forecast information and wind forecast information, and if the result of the comparison yields to a deviation, the monitoring device increases the detected risk of fraudulent green energy production.

In an embodiment, the smart meter is a gross meter and the comparison of the total theoretical energy production with an energy production provided by the smart meter is done for a short interval of time and the related deviation is an instantaneous deviation.

In an embodiment, the smart meter is a gross meter and the comparison of the total theoretical energy production with an energy production provided by the smart meter is done for a long interval of time and the related deviation is an average deviation.

In an embodiment, the smart meter is a gross meter and the comparison of the total theoretical energy production with an energy production provided by the smart meter is done for a short interval of time and for a long interval of time and the related deviations are respectively an instantaneous deviation and an average deviation, and if the comparisons yield to an instantaneous deviation and an average deviation, a high risk of fraudulent green energy production is detected.

In an embodiment, the smart meter is a net meter and the energy production provided by the smart meter is evaluated by adding an energy consumed by the household to an energy measured by the smart meter.

In another implementation a monitoring device for detecting fraudulent green energy producers, the monitoring device being linked to a smart meter associated with a household and comprising:

means for calculating a total theoretical energy production for the household, by adding an estimated solar energy production and an estimated wind energy production,
means for comparing the total theoretical energy production with an energy production provided by the smart meter,
means for detecting a risk of fraudulent green energy production, if the comparison yields to a deviation.

In another implementation a computer-readable medium having embodied thereon a computer program for executing a method for detecting fraudulent green energy producers. Said computer program comprises instructions which carry out steps according to the method according to the invention.

BRIEF DESCRIPTION OF THE FIGURES

The detailed description is described with reference to the accompanying figures. In the figures, the left-most digit(s) of a reference number identifies the figure in which the reference number first appears. The same numbers are used throughout the figures to reference like features and components. Some embodiments of system and/or methods in accordance with embodiments of the present subject matter are now described, by way of example only, and with reference to the accompanying figures, in which:

Figure 1 illustrates a schematic block diagram of a communication system according to one embodiment of the invention for detecting fraudulent green energy producers.

Figure 2 illustrates a flow chart illustrating a method for detecting fraudulent green energy producers according to one embodiment of the invention.

The same reference number represents the same element or the same type of element on all drawings.

It should be appreciated by those skilled in the art that any block diagrams herein represent conceptual views of illustrative systems embodying the principles of the present subject matter. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

DESCRIPTION OF EMBODIMENTS

The figures and the following description illustrate specific exemplary embodiments of the invention. It will thus be appreciated that those skilled in the art will be able to devise various arrangements that, although not explicitly described or shown herein, embody the principles of the invention and are included within the scope of the invention. Furthermore, any examples described herein are intended to aid in understanding the principles of the invention, and are to be construed as being without limitation to such specifically recited examples and conditions. As a result, the invention is not limited to the specific embodiments or examples described below, but by the claims and their equivalents.

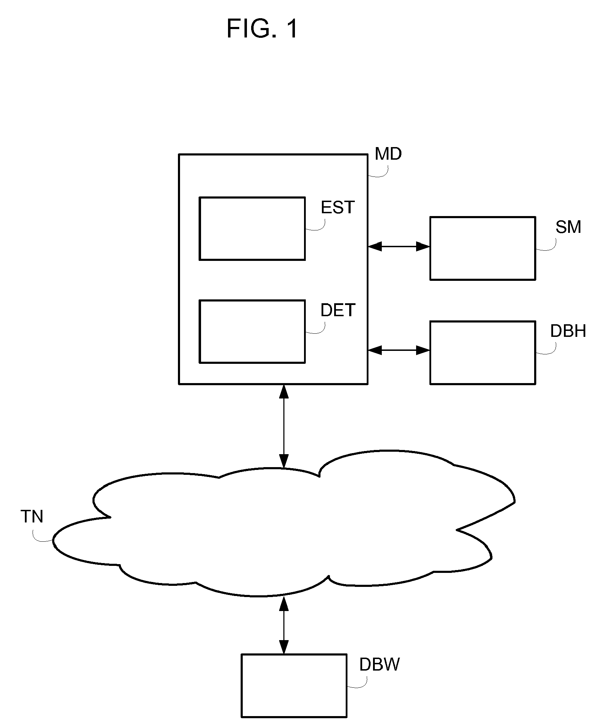

Referring to FIG. 1, a communication system comprises a smart meter SM linked to a monitoring device MD. The monitoring device may be included in the smart meter SM or linked to it via a wireless or wired connection.

The smart meter SM is an electronic device that records consumption of electric energy in different time intervals and communicates that information periodically back to the utility for monitoring and billing. For example, the smart meter uses A/C current transducers coupled to the power wires incoming to homes. The smart meter may have two components - one component typically resides in the utility room and has two current transducers (one per A/C phase) with a low-power radio transmitter that relays its sensor measurement data via RF, and a second component which is a receiver/display located somewhere in the interior of the home. By viewing the receiver/display component, a consumer can see total current electrical consumption in real-time along with some comparison data such as morning, afternoon and evening summaries.

The smart meter contains or is directly linked to a household information database DBH that contains information related to the electricity production units of the household. For example, the information relates to :

- Location coordinates of the household;
- Wind related production means: turbine model or size;
- Solar related production means: panel surfaces, types/modes, age (since efficiency declines over time).

The smart meter may be a gross meter or a net meter. Gross meter can measure separately the produced energy (from renewable sources) and the consumed energy (for personal use of the client). A sensitivity corresponding to a margin of error can be set by the operator. Net meter can only measure the excess value of the energy that remains after deducting the energy consumed by the client. In other words, the energy measured by the net meter and declared for billing is equal to the subtraction of the energy consumed by the household to the produced energy (by all means). Thus the produced energy is evaluated by adding the energy consumed to the energy measured. While the energy measured is provided by the net meter, the energy consumed is evaluated based on a usage history database. This usage history database, which is managed by the grid operator, stores the average consumption of the households. The data related to the consumption can be calculated from previous measured consumption data and/or the profile/size of the household.

The monitoring device MD communicates with a weather database DBW via a telecommunication network TN that may be a wired or wireless network, or a combination of wired and wireless networks. The weather database DBW, usually provided by a weather/forecast agency, stores the weather information that can be relevant for (green) electricity generation. In the remainder of the description, two types of green electricity generation are considered: Solar and Wind power generation. Hence, the weather database DBW includes the following:

- Information to wind (e.g. Wind speed): Info_Wind(t,location)
- Information related to sun (e.g. intensity, angle): Info_Sun (t, location).

In one embodiment, the monitoring device MD and the smart meter SM are separated by a network. The smart meter can be located in the operator side and linked to sevarl smart meters. In this embodiment, the monitoring device cannot be manipulated by a user of the household.

The monitoring device MD comprises an estimation module EST and a detection module DET.

The estimation module EST estimates production of electricity coming from green like solar energy and wind energy.

The estimation module EST calculates the theoretical output of energy production of the household using solar energy. The production Ps depends on a function "f" of time taking into account information related to the solar panels (panel_surface_i, panel_type_i, panel_age_i(t), panel_location_i) and solar forecast information (info_solar(t, panel_location_i)). The production Ps of solar energy can be defined as the sum (Sum_over_panel_i) of different panels with different surfaces (panel_surface_i) as the following :

$$Ps (t) = Sum\_over\_panel\_i \; [f(panel\_surface\_i, \; panel\_type\_i, \; panel\_age\_i(t),$$
$$panel\_location\_i, \; info\_solar(t, \; panel\_location\_i))]$$

The estimation module EST calculates the theoretical output of energy production of the household using wind energy. The production Pw depends on a function "f" of time taking into account information related to the turbines (turbine_type_i, turbine_age_i(t), turbine_location_i) and wind forecast information (info_wind(t, turbine_location_i)). The production Pw of wind energy can be defined as the sum (Sum_over_turbine_i) of different turbines as the following:

$$Pw (t) = Sum\_over\_turbine\_i \; [f(turbine\_type\_i, \; turbine\_age\_i(t),$$
$$turbine\_location\_i, \; info\_wind(t, \; turbine\_location\_i))]$$

The estimation module EST calculates the total theoretical production Pt of energy for the household, by adding the solar energy production Ps and the wind energy production Pw.

The detection module DET, in case of a gross meter, compares the total theoretical production Pt with a measured energy provided by the smart meter or in other words with the production Pm of energy provided by the smart meter for a short interval of time to be defined by the operator, over some hours for example. The comparison is done in order to detect any deviation between the theoretical and indicated energy real time output of the household. A first threshold Ti defined as sensitivity or a margin of error can be set by the operator.

If the absolute difference between the total theoretical production Pt and the indicated production Pm is above said first threshold Ti, then the detection module DET detects an instantaneous deviation or an instantaneous anomaly.

The detection module DET compares the cumulative energy of the total theoretical production Pt with the cumulative energy provided by the smart meter for a long interval of time to be defined by the operator, over a day or a week for example. A second threshold Ta defined as sensitivity or a margin of error can be set by the operator.

If the absolute difference between the cumulative total theoretical production Pt and the indicated cumulative production Pm is above said second threshold Ta, then the detection module DET detects an average deviation or an average anomaly.

The detection module DET, in case of a gross meter, can distinguish a medium risk of fraud if there is a single anomaly detection and a high risk of fraud if there a double anomaly detection.

If an anomaly is detected, the detection module DET stores in a database an identifier of the household that is fraud suspect, with the associated magnitude of probability (medium/high) in case of a gross meter.

In another embodiment, the monitoring device MD can consult a consolidated operator database storing information about the different household information databases DBH that contain information related to the electricity production units of the corresponding household and storing a history of energy productions related to each household. The monitoring device MD can further compare the energy production Pm provided by a given smart meter with selected energy productions Pm provided by other smart meters or with an average of selected energy productions Pm provided by other smart meters, the other smart meters being located in the same area as the given smart meter and being associated with electricity production units having similar properties. If the result of the comparison yields to a deviation, the monitoring device increases the detected risk of fraudulent green energy production.

In another embodiment, the monitoring device MD can consult a consolidated operator database storing information about the different household information databases DBH that contain information related to the electricity production units of the corresponding household and storing a history of energy productions related to households located in the same area as the given smart meter. The monitoring device MD can further calculate an average of the solar forecast information and wind forecast information for households from the energy production. The monitoring device then compares the solar forecast information and wind forecast information for a given smart meter with the calculated solar forecast information and wind forecast information from the consolidated operator database. If the result of the comparison yields to a deviation, the monitoring device increases the detected risk of fraudulent green energy production. It is presumed that the forecast information should be the same for all smart meters located in the same area, then a deviation related to the forecast information means an anomaly like an attempt of fraud of production of green energy.

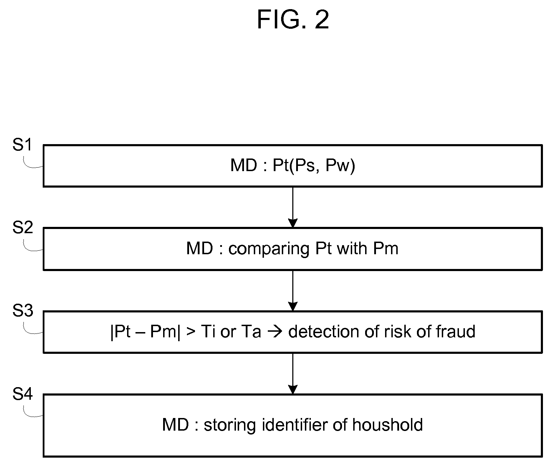

With reference to FIG. 2, a method for detecting fraudulent green energy producers according to one embodiment of the invention comprises steps S1 to S4 executed within the communication system.

In step S1, the monitoring device MD calculates the total theoretical energy production Pt for the household, by adding an estimated solar energy production Ps and an estimated wind energy production Pw. It is assumed that if the household only uses one of the solar and wind energy production means, the estimated energy production corresponding to the other one is equal to zero.

In step S2, the monitoring device MD compares the total theoretical energy production Pt with the energy production Pm provided by the smart meter. The monitoring device MD performs a difference between the total theoretical energy production Pt and the energy production Pm provided by the smart meter.

In step S3, if the result of the difference is above a threshold Ta or Ti, in other words results in a deviation or an anomaly, then the monitoring device MD detects a risk of a fraudulent green energy production and thus a fraudulent attempt by the client to send false measurement to the electricity company. In one example, the threshold may be comprised between a range of one to five percent.

In step S4, the monitoring device MD stores in a database an identifier of the household that is fraud suspect, in association with a magnitude of the risk.

An embodiment comprises a monitoring device comprising one or more processor(s), I/O interface(s), and a memory coupled to the processor(s). The processor(s) may be implemented as one or more microprocessors, microcomputers, microcontrollers, digital signal processors, central processing units, state machines, logic circuitries, and/or any devices that manipulate signals based on operational instructions. The processor(s) can be a single processing unit or a number of units, all of which could also include multiple computing units. Among other capabilities, the processor(s) are configured to fetch and execute computer-readable instructions stored in the memory.

The functions realized by the processor may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included.

The memory may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes. The memory includes modules and data. The modules include routines, programs, objects, components, data structures, etc., which perform particular tasks or implement particular abstract data types. The data, amongst other things, serves as a repository for storing data processed, received, and generated by one or more of the modules.

A person skilled in the art will readily recognize that steps of the methods, presented above, can be performed by programmed computers. Herein, some embodiments are also intended to cover program storage devices, for example, digital data storage media, which are machine or computer readable and encode machine-executable or computer-executable programs of instructions, where said instructions perform some or all of the steps of the described method. The program storage devices may be, for example, digital memories, magnetic storage media, such as a magnetic disks and magnetic tapes, hard drives, or optically readable digital data storage media.

## Claims

1. A method for detecting fraudulent green energy producers, the method comprising the following steps in a monitoring device (MD) linked to a smart meter associated with a household:

   calculating (S1) a total theoretical energy production (Pt) for the household, by adding an estimated solar energy production (Ps) and an estimated wind energy production (Pw),
   comparing (S2) the total theoretical energy production (Pt) with an energy production (Pm) provided by the smart meter,
   if the comparison yields to a deviation, detecting (S3) a risk of fraudulent green energy production.

2. The method as claimed in claim 1, wherein the monitoring device stores in a database an identifier of the household that is fraud suspect.

3. The method as claimed in claim 1 or 2, wherein the monitoring device performs a difference between the total theoretical energy production and the energy production provided by the smart meter and compares the result of the difference with a threshold, and said comparison yields to a deviation if the result of the difference is above a given threshold.

4. The method as claimed in any of the preceding claims, wherein the estimated solar energy production (Ps) depends on a function of time taking into account information related to solar panels associated with the household and solar forecast information.

5. The method as claimed in any of the preceding claims, wherein the estimated wind energy production (Pw) depends on a function of time taking into account information related to turbines associated with the household and wind forecast information.

6. The method as claimed in claims 4 and 5, wherein the monitoring device consults a database storing information about the electricity production units of other households located in the same area as said household and storing a history of energy productions related to said other households, calculates an average of each of the solar forecast information and wind forecast information from the energy productions related to said other households, compares the solar forecast information and wind forecast information for said smart meter with the calculated average of solar forecast information and wind forecast information, and if the result of the comparison yields to a deviation, the monitoring device increases the detected risk of fraudulent green energy production.

7. The method as claimed in any of the preceding claims, wherein the smart meter is a gross meter and the comparison of the total theoretical energy production (Pt) with an energy production (Pm) provided by the smart meter is done for a short interval of time and the related deviation is an instantaneous deviation.

8. The method as claimed in any of the preceding claims, wherein the smart meter is a gross meter and the comparison of the total theoretical energy production (Pt) with an energy production (Pm) provided by the smart meter is done for a long interval of time and the related deviation is an average deviation.

9. The method as claimed in any of the preceding claims, wherein the smart meter is a gross meter and the comparison of the total theoretical energy production (Pt) with an energy production (Pm) provided by the smart meter is done for a short interval of time and for a long interval of time and the related deviations are respectively an instantaneous deviation and an average deviation, and if the comparisons yield to an instantaneous deviation and an average deviation, a high risk of fraudulent green energy production is detected.

10. The method as claimed in claim 3, wherein the smart meter is a net meter and the energy production provided by the smart meter is evaluated by adding an energy consumed by the household to an energy measured by the smart meter.

11. A monitoring device for detecting fraudulent green energy producers, the monitoring device (MD) being linked to a smart meter associated with a household and comprising:

means (EST) for calculating a total theoretical energy production (Pt) for the household, by adding an estimated solar energy production (Ps) and an estimated wind energy production (Pw),
means (DET) for comparing the total theoretical energy production (Pt) with an energy production (Pm) provided by the smart meter,
means (DET) for detecting a risk of fraudulent green energy production, if the comparison yields to a deviation.

12. A computer-readable medium having embodied thereon a computer program for executing a method for detecting fraudulent green energy producers according to any of claims 1 to 10:

# FIG. 1

# FIG. 2

S1 | MD : Pt(Ps, Pw)

S2 | MD : comparing Pt with Pm

S3 | $|Pt - Pm| > Ti$ or Ta → detection of risk of fraud

S4 | MD : storing identifier of houshold

Europäisches
Patentamt

European
Patent Office

Office européen
des brevets

## EUROPEAN SEARCH REPORT

Application Number

EP 16 30 5963

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/098954 A1 (FALK RAINER [DE] ET AL) 28 April 2011 (2011-04-28) | 1,3,6-12 | INV. H02J3/38 G06Q50/06 |
| Y | * abstract; figures 1,2 * <br> * paragraph [0004] - paragraph [0011] * <br> * paragraph [0019] - paragraph [0020] * <br> * paragraph [0023] - paragraph [0025] * <br> * paragraph [0029] - paragraph [0032] * <br> * paragraph [0039] * | 2,4,5 | ADD. G06Q10/04 G01R22/06 H02J3/00 |
| X | DE 10 2011 003149 A1 (BOSCH GMBH ROBERT [DE]) 26 July 2012 (2012-07-26) <br> * paragraphs [0002], [0012], [0013], [0018] - paragraphs [0029], [0030], [0036], [0037]; figures 1,3,4 * <br> * paragraph [0040] - paragraph [0043] * | 1,3,11, 12 | |
| X | CN 203 479 855 U (STATE GRID CORP CHINA; CHINA ELECTRIC POWER RES INST) 12 March 2014 (2014-03-12) <br> * abstract; figure 1 * | 1,11 | |
| Y | US 2014/236508 A1 (MCGOWAN MICHAEL [US] ET AL) 21 August 2014 (2014-08-21) | 2 | TECHNICAL FIELDS SEARCHED (IPC) H02J G06Q G01R |
| A | * paragraphs [0008], [0018] - [0022], [0033], [0037]; figures 1-3 * | 1,6,8,9 | |
| Y | WO 2008/124185 A1 (LIVE DATA SYSTEMS INC [US]; BRZEZOWSKI EDWARD H [US]; GRABOWSKI JOSEPH) 16 October 2008 (2008-10-16) | 4,5 | |
| A | * abstract; figures 1,4,6 * <br> * paragraph [0007] - paragraph [0011] * | 6 | |

The present search report has been drawn up for all claims

| Place of search | Date of completion of the search | Examiner |
|---|---|---|
| Munich | 29 September 2016 | Ossanna, Luca |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 16 30 5963

This annex lists the patent family members relating to the patent documents cited in the above-mentioned European search report.
The members are as contained in the European Patent Office EDP file on
The European Patent Office is in no way liable for these particulars which are merely given for the purpose of information.

29-09-2016

| Patent document cited in search report | | Publication date | Patent family member(s) | | Publication date |
|---|---|---|---|---|---|
| US 2011098954 | A1 | 28-04-2011 | CN 102066952 A<br>EP 2286249 A1<br>US 2011098954 A1<br>WO 2009149731 A1 | | 18-05-2011<br>23-02-2011<br>28-04-2011<br>17-12-2009 |
| DE 102011003149 | A1 | 26-07-2012 | DE 102011003149 A1<br>EP 2668470 A2<br>WO 2012101084 A2 | | 26-07-2012<br>04-12-2013<br>02-08-2012 |
| CN 203479855 | U | 12-03-2014 | NONE | | |
| US 2014236508 | A1 | 21-08-2014 | NONE | | |
| WO 2008124185 | A1 | 16-10-2008 | CA 2683487 A1<br>EP 2062140 A1<br>US 2009088991 A1<br>WO 2008124185 A1 | | 16-10-2008<br>27-05-2009<br>02-04-2009<br>16-10-2008 |

EPO FORM P0459

For more details about this annex : see Official Journal of the European Patent Office, No. 12/82